(19) Europäisches Patentamt
European Patent Office
Office européen des brevets

(11) **EP 1 903 612 B1**

(12) **FASCICULE DE BREVET EUROPEEN**

(45) Date de publication et mention
de la délivrance du brevet:
**08.10.2014 Bulletin 2014/41**

(51) Int Cl.:
**H01L 31/0352** *(2006.01)* **H01L 31/107** *(2006.01)*

(21) Numéro de dépôt: **07301361.7**

(22) Date de dépôt: **14.09.2007**

(54) **Photodiode à avalanche**

Fotodiode mit Lawine

Avalanche photodiode

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **18.09.2006 FR 0653799**

(43) Date de publication de la demande:
**26.03.2008 Bulletin 2008/13**

(73) Titulaire: **Commissariat à l'Énergie Atomique et aux Énergies Alternatives
75015 Paris (FR)**

(72) Inventeur: **Rothman, Johan
38250, LANS EN VERCORS (FR)**

(74) Mandataire: **Vuillermoz, Bruno et al
Cabinet Laurent & Charras
"Le Contemporain"
50, Chemin de la Bruyère
69574 Dardilly Cédex (FR)**

(56) Documents cités:
**US-A- 4 481 523 US-A- 5 185 648**

• **MUSCA C A ET AL: "Laser beam induced current as a tool for HgCdTe photodiode characterisation" MICROELECTRONICS JOURNAL, MACKINTOSH PUBLICATIONS LTD. LUTON, GB, vol. 31, no. 7, 30 juillet 2000 (2000-07-30), pages 537-544, XP004213264 ISSN: 0026-2692**
• **J. BECK ET AL.: "The HgCdTe Electron Avalanche Photodiode" PROCEEDINGS OF SPIE, vol. 5564, 4 août 2004 (2004-08-04), pages 44-53, XP002444174**

**Description**

## DOMAINE DE L'INVENTION

La présente invention concerne une photodiode destinée, par définition, à capter des photons, notamment lorsqu'elle fonctionne sous une polarisation inverse en mode avalanche.

Par ailleurs, la présente invention a pour objet un détecteur composé d'une juxtaposition de telles photodiodes.

La présente invention se rapporte donc au domaine des composants et détecteurs optoélectroniques.

## ETAT ANTERIEUR DE LA TECHNIQUE

De manière connue, on utilise les diodes à effet d'avalanche pour détecter des flux de photons incidents de manière relativement sensible et/ou de manière relativement rapide, c'est-à-dire avec de courts temps de réponse. En effet, une photodiode à avalanche permet de détecter avec amplification des photoporteurs lorsque la polarisation inverse est suffisante pour déclencher une avalanche dans la zone de multiplication.

Ainsi, les photodiodes à avalanche offrent diverses possibilités d'applications, parmi lesquelles on peut citer la réalisation de plans focaux de détection pour l'imagerie active, la détection rapide dans le domaine des télécommunications, la spectroscopie, la détection de flux lumineux très faible, voire le comptage de photons.

De manière connue, la polarisation inverse d'une diode permet d'accélérer les porteurs de charge libres sous l'effet du champ électrique appliqué dans la zone de déplétion située entre les couches dopées de type N et les couches dopées de type P. Une telle accélération des porteurs de charge libres leur confère, selon les caractéristiques de la diode, une énergie suffisante pour engendrer une ionisation par impact, créant des paires électron - trou supplémentaires.

On obtient ainsi, un effet d'avalanche, c'est-à-dire la multiplication du nombre de photoporteurs à partir d'un faible nombre de photoporteurs initiaux. Dans ce cas, le courant détecté par la photodiode vaut :

$I_{DA}=M.I_{CC}$, où :

- $I_{DA}$ est le courant détecté par la diode à avalanche ;
- $I_{CC}$ est le courant détecté par la diode sous polarisation nulle ;
- M représente le gain de la diode ou le facteur de multiplication dû à l'effet d'avalanche.

Cependant, dans la plupart des diodes à avalanche de l'art antérieur, une telle amplification des faibles courants conduit à une amplification du bruit électronique et donc à une dégradation du rapport signal sur bruit du détecteur. Ainsi, la densité de bruit électronique moyen dans le courant amplifié d'une photodiode à avalanche vaut :

$i_{B-DA}=M.(2.q.I_{CC}.F)^{1/2}$, où :

- q est la charge d'un électron ;
- F est le facteur de bruit.

Idéalement le facteur de bruit F vaut 1, c'est-à-dire que la diode à avalanche amplifie le courant sans ajouter de bruit au signal reçu par le détecteur.

De manière connue, le facteur de bruit F dépend fortement du déroulement de la multiplication des porteurs de charge. Par conséquent, il dépend de la forme de la jonction P-N de la diode et du matériau constitutif de la zone de déplétion, où se déroule la multiplication.

Le facteur de bruit est lié à la distribution de probabilité du gain pour un photoporteur généré dans la diode

$$F = 1 + \frac{\sigma_M{}^2}{M^2}$$

où $\sigma_M$ et M sont l'écart type et la moyenne de la distribution de probabilité du gain d'avalanche.

Cette distribution dépend du matériau utilisé et de la forme de la jonction. En particulier, si l'ionisation par impact est engendrée par les trous et les électrons, la multiplication est très aléatoire et le facteur de bruit est important (F > 2). En revanche, dans un matériau où la multiplication est dominée par les électrons ou les trous, le facteur de bruit est faible, inférieur ou égal à 2. Dans ce cas, le facteur de bruit dépend du processus d'accélération et d'ionisation des porteurs dans la zone de déplétion, ce processus dépendant du matériau et de la forme de la jonction.

Ainsi, dans les applications de télécommunication et de télémétrie par laser où l'on détecte des rayons proches de l'infrarouge, les matériaux semi-conducteurs employés pour former les photodiodes sont des alliage d'indium (In), de gallium (Ga), d'arsenic (As) et de phosphore (P), tels que les alliages InGaAs et InGaAsP. De telles photodiodes, lorsqu'elles sont convenablement polarisées en inverse, effectuent la multiplication des porteurs avec des contributions équivalentes des électrons et des trous. Ces photodiodes présentent donc un facteur de bruit F important et typiquement supérieur à 2.

C'est pourquoi on a alors réalisé des photodiodes à partir d'alliages de cadmium (Cd), de mercure (Hg) et de tellure (Te), de formule générale $Hg_{1-x}Cd_xTe$, où x, compris entre 0 et 1, représente la fraction de cadmium dans la composition de l'alliage.

Ainsi, pour des matériaux dont la fraction x vaut environ 0,3 et qui sont employés pour détecter un rayonnement infrarouge de longueur d'onde moyenne, on obtient une multiplication essentiellement déclenchée par les électrons, donc un facteur de bruit F et une dégradation du rapport signal sur bruit relativement faible. De plus, à basse température (77 K) et sous faible polarisation inverse (moins de 10 V), cette multiplication conduit à des gains M élevés, typiquement supérieurs à 100.

En revanche, pour des alliages où la fraction x est supérieure à 0,55 et qui sont employés pour détecter des rayons de l'infrarouge proche, ce sont les trous qui dominent la multiplication des porteurs, mais seulement faiblement, si bien que le facteur de bruit F devient supérieur ou égal à 2, dégradant ainsi le rapport signal sur bruit du détecteur.

Par ailleurs, on cherche également à minimiser le courant d'obscurité qui traverse une photodiode à avalanche. En effet, de manière connue, le courant d'obscurité contribue à la dégradation du rapport signal sur bruit du détecteur pour le flux photonique le plus faible à mesurer, limitant ainsi la sensibilité du détecteur pour une polarisation donnée. On cherche aussi à augmenter le gain d'avalanche.

Dans ce but, une solution de l'art antérieur consiste à séparer la région où se multiplient les photoporteurs de la région où se déroulent les interactions avec les photons incidents. En pratique, cette séparation est obtenue en réalisant par exemple une région de multiplication présentant une largeur de bande interdite supérieure à celle de la bande interdite de la région d'interaction.

Il est aussi possible d'ajouter d'autres régions fonctionnelles permettant d'améliorer d'autres paramètres de fonctionnement de la diode, comme par exemple l'homogénéïté du gain ou la diminution de sa tension de polarisation en fonctionnement et du facteur de bruit.

Outre le choix des matériaux constituant la diode et de leur dopage, l'art antérieur propose une construction particulière pour réduire le courant d'obscurité. Dans cette construction, on réalise un anneau de garde, autour et à distance de la jonction P-N. Cet anneau de garde permet de limiter les effets de concentration des champs électriques qui agissent dans la diode.

Les photodiodes de l'art antérieur ont pour caractéristique commune une jonction P-N réalisée selon une surface sensiblement perpendiculaire à l'empilement des couches fonctionnelles, telle que la couche d'interaction où sont absorbés les photons incidents. L'article intitulé « The HgCdTe Electron Avalanche Photodiode » paru dans Proc. SPIE (vol.5564, pp.44-53) présente de telles photodiodes à structure « verticale ». Ainsi, les interfaces entre régions de type P, zone de déplétion, et région de type N se trouvent perpendiculaires à la surface du plan de détection dans le cas d'un détecteur matriciel.

Les photodiodes de l'art antérieur sont parcourues par des courants d'obscurité normalisés par le gain, compris entre 0,1 $\mu A/cm^2$ et 1 $\mu A/cm^2$ pour des gains compris entre 30 et 1000 à 77 K, le facteur de bruit étant généralement maintenu aux environs de 1 pour une longueur d'onde à détecter inférieure à 5 $\mu m$

Ce courant d'obscurité limite la sensibilité du détecteur. En outre, le courant d'obscurité est d'autant plus grand que la température de fonctionnement de la photodiode est élevée. Par conséquent, la sensibilité se dégrade lorsque le détecteur fonctionne à température élevée.

La présente invention a pour objet une photodiode et un détecteur ne présentant pas les inconvénients de l'art antérieur.

**EXPOSE DE L'INVENTION**

La présente invention concerne une photodiode et un détecteur composé d'une juxtaposition de photodiodes présentant un facteur de bruit F proche de 1 et un courant d'obscurité relativement faible. Le gain de la photodiode objet de l'invention peut être élevé sous faible polarisation inverse, sans pour autant dégrader le rapport signal sur bruit du détecteur, notamment lors de la détection de rayonnements infrarouges et/ou visibles.

L'objet de l'invention est une photodiode dont les caractéristiques sont données dans la revendication 1 destinée à capter des photons incidents, comprenant un empilement d'au moins trois couches superposées en matériaux semi-conducteurs présentant un premier type de conductivité. Cet empilement comporte :

- une couche d'interaction destinée à interagir avec les photons de façon à générer des photoporteurs ;
- une couche de collecte de ces photoporteurs ;
- une couche de confinement destinée à confiner les photoporteurs au niveau de la couche de collecte.

Selon l'invention, la couche de collecte présentant une largeur de bande interdite inférieure aux largeurs de bande interdite des couches d'interaction et de confinement, et la photodiode comprend en outre une région s'étendant transversalement par rapport aux plans des couches, la région étant en contact avec la couche de collecte et la couche de confinement, et présentant un type de conductivité opposé au premier type de conductivité de façon à former une jonction P-N avec l'empilement.

En d'autres termes, la structure de la photodiode de l'invention est composée de couches s'étendant parallèlement au plan de détection, hormis une région disposée en travers des couches parallèles superposées et inversement dopée pour former une jonction P-N.

Selon une forme de réalisation de l'invention, ladite région s'étend partiellement dans la couche d'interaction.

Avantageusement, la couche de collecte est plus mince que la couche d'interaction. En effet, le courant d'obscurité et l'interaction des rayonnements perturbateurs seront d'autant plus faibles que ladite couche sera mince.

En pratique, la couche de collecte peut posséder une épaisseur inférieure à 0,5 $\mu m$, tandis que la couche d'interaction peut posséder une épaisseur supérieure à 1 $\mu m$.

De telles épaisseurs permettent à ces couches de remplir leurs fonctions de collecte et d'interaction avec un encombrement limité et une sensibilité négligeable aux rayonnements perturbateurs.

Avantageusement, le matériau constituant la couche d'interaction présente un gradient de largeur de bande interdite.

En pratique, la couche de confinement peut être recouverte d'une première couche de passivation.

Avantageusement, un plot de lecture est réalisé de telle sorte à être en contact avec la région, et destiné à transmettre les signaux électriques formés par les photoporteurs à un circuit d'exploitation.

Selon une forme de réalisation particulière de l'invention, la région s'étendant transversalement peut s'étendre à partir d'une forme en creux.

En pratique, le premier type de conductivité est le type P. Un tel dopage des couches d'interaction, de collecte et de confinement permet de réaliser une photodiode performante.

Selon une forme de réalisation particulière de l'invention, les couches d'interaction et de collecte peuvent être constituées d'un alliage de mercure, de cadmium et de tellure selon la formule $Hg_{1-x}Cd_xTe$. De plus, la fraction x est choisie entre 0,1 et 0,5 pour la couche de collecte et, est choisie entre 0,1 et 1 pour la couche d'interaction.

Un tel alliage permet de réaliser une photodiode à faible facteur de bruit et à faible courant d'obscurité pour un gain de multiplication important à faible polarisation.

Selon une autre forme de réalisation de l'invention, la couche de collecte peut comprendre un empilement de couches superposées en matériaux semi-conducteurs, la couche centrale présentant une largeur de bande interdite inférieure aux largeurs de bande interdite des couches périphériques, de manière à amoindrir la transition entre la couche de collecte et les couches d'interaction et de confinement.

En d'autres termes, la couche de collecte est encadrée par deux couches d'insertion qui représentent une gradation d'une part vers la couche d'interaction et d'autre part vers la couche de confinement. Cela permet de réduire, voire d'éviter la formation de défauts au niveau des hétérojonctions d'interface de la couche de collecte et, partant, de réduire le courant d'obscurité et d'augmenter la résistance de la diode à une tension de polarisation inverse.

L'invention concerne également une photodiode se présentant sous la forme de mésa. Selon l'invention, cette photodiode est délimitée par une zone exempte de matière s'étendant en profondeur sur toute la hauteur des couches de collecte et de confinement et sur une partie de la hauteur de la couche d'interaction, la partie de l'empilement située dans cette zone étant recouverte par une deuxième couche de passivation, qui peut être la première couche de passivation.

En d'autres termes, chaque photodiode est individualisée et forme une saillie au dessus d'un substrat commun constitué par les couches d'interaction de toutes les photodiodes juxtaposées. Cela permet de diminuer le volume de diffusion que les photoporteurs doivent parcourir avant d'être collectés au niveau de la jonction P-N. En effet, les couches dopées selon le premier type de conductivité ont une forme convergeant globalement vers la couche de type de conductivité opposée. Par conséquent, cette caractéristique permet de diminuer le temps de réponse d'un tel détecteur et son courant d'obscurité.

Selon une forme de réalisation pratique du détecteur de l'invention, la deuxième couche de passivation peut être recouverte par une couche de métallisation.

Une telle couche de métallisation permet, sous une tension de polarisation appropriée, d'accumuler des porteurs de charge à l'interface entre les matériaux semi-conducteurs et la couche de passivation, par nature neutre, c'est-à-dire au niveau des flancs des « mesas ». Les porteurs de charge ainsi accumulés forment un champ électrique apte à accélérer davantage les photoporteurs vers la jonction P-N, ce qui contribue à diminuer le temps de réponse du détecteur.

L'invention vise également un détecteur de rayonnements électromagnétiques comprenant la juxtaposition d'au moins deux de ces photodiodes.

L'invention concerne aussi un détecteur bispectral de rayonnement électromagnétique comprenant au moins une photodiode telle que précédemment exposée destinée à capter des photons d'un premier spectre d'énergie, sur laquelle est disposée une diode planaire comprenant une couche d'absorption destinée à capter des photons d'un deuxième spectre d'énergie ainsi qu'une zone de jonction P-N reliée à un plot électriquement conducteur, cette couche d'absorption présentant un puits communiquant avec ladite région, une couche passivante recouvrant cette couche d'absorption et une couche de métallisation recouvrant ladite région et cette couche passivante sur une partie dudit puits, ce plot et cette couche de métallisation étant aptes à conduire les signaux électriques de ladite photodiode vers un circuit d'exploitation.

En outre, selon une variante, on peut même optimiser le fonctionnement d'un tel détecteur bispectral en revêtant la couche d'interaction sur sa face opposée à celle recevant la couche de collecte, d'une couche supplémentaire, faisant fonction de filtre.

## BREVE DESCRIPTION DES FIGURES

La figure 1 est une représentation schématique en section d'une photodiode exempte de toute gravure. La figure 2 est une représentation schématique en section d'une photodiode conforme à l'invention. Sur la gauche de la figure 2, on a représenté le diagramme de la composition des matériaux semi conducteurs constituant les différentes couches de cette photodiode. Les niveaux d'énergie des bandes interdites peuvent être déduits de ce diagramme.

La figure 3 est une représentation schématique en section d'une photodiode conforme à une variante de la photodiode illustrée par la figure 2. Sur la gauche de la figure 3, on a représenté le diagramme de la composition des matériaux semi conducteurs constituant les différentes couches de cette photodiode. Les niveaux d'énergie des bandes interdites peuvent être déduits de ce diagramme.

La figure 4 est une représentation schématique en section présentant deux photodiodes juxtaposées appartenant à un détecteur conforme à l'invention.

La figure 5 est une représentation schématique en section présentant deux photodiodes juxtaposées appartenant à un détecteur conforme à une variante du détecteur illustré par la figure 4.

La figure 6 est une représentation schématique d'une photodiode d'un détecteur bispectral conforme à l'invention, dont la figure 7 est une variante.

La figure 8 présente la réponse spectrale d'un détecteur selon la forme de réalisation illustrée par la figure 7.

## MODE DE REALISATION DE L'INVENTION

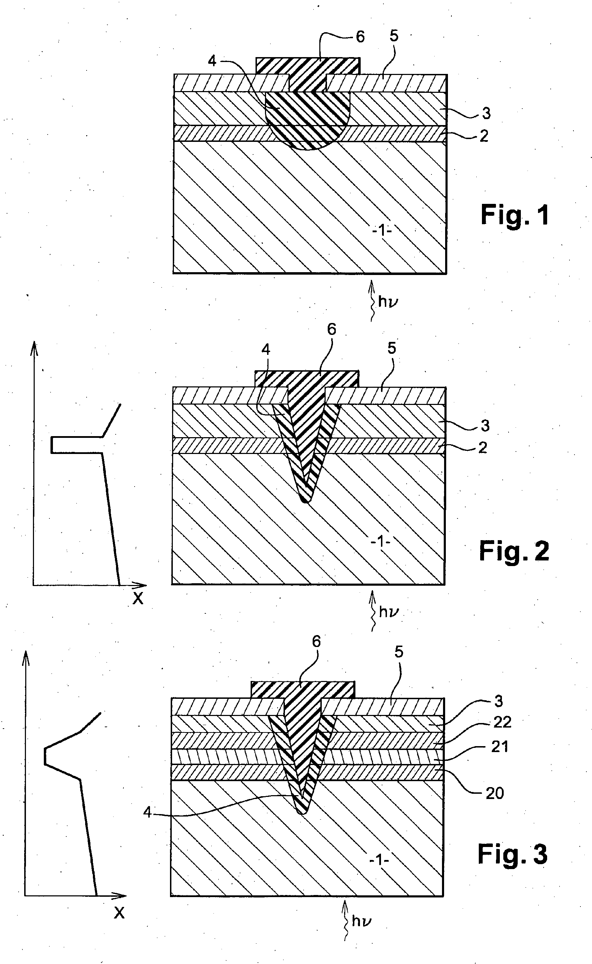

La figure 1 illustre donc une diode conforme à une première forme de réalisation de l'invention, dans laquelle une couche d'interaction **1** est destinée à interagir avec des photons incidents d'un rayonnement électromagnétique, tel que les rayons infrarouges ou des rayons de lumière visible. La couche d'interaction **1** s'étend donc de préférence transversalement, voire perpendiculairement, à la direction des photons incidents à détecter.

En pratique, la couche **1** est constituée d'un matériau semi-conducteur d'un premier type de conductivité, par exemple un alliage de mercure, de cadmium et de tellure selon la formule $Hg_{1-x}Cd_xTe$. L'épaisseur de la couche d'interaction, c'est-à-dire la dimension considérée selon la hauteur sur les figures 1 à 6, est choisie en fonction de la longueur d'onde du rayonnement à détecter.

Ainsi, lorsqu'il s'agit de détecter des rayons infrarouges de longueur d'ondes courtes ($\lambda$, < 3 $\mu$m), moyennes (3 $\mu$m < $\lambda$ < 6 $\mu$m) ou longues ($\lambda$ > 6 $\mu$m), l'épaisseur de la couche d'interaction **1** peut être supérieure à 1 $\mu$m, 3 $\mu$m ou 6 $\mu$m respectivement.

La couche d'interaction **1** est revêtue, par des techniques de dépôt conventionnelles, d'une couche de collecte **2** destinée à collecter les photoporteurs libérés lors des interactions entre les rayons incidents et la couche d'interaction **1**. A l'instar de la couche d'interaction **1**, la couche de collecte **2** est constituée d'un matériau semi conducteur, tel qu'un alliage de mercure, de cadmium et de tellure selon la formule $Hg_{1-x}Cd_xTe$, présentant le même type de conductivité que la couche d'interaction **1**, mais avec un gap inférieur.

L'épaisseur de la couche de collecte **2** est suffisante pour permettre la circulation des photoporteurs provenant de la couche d'interaction **1**. Elle est réduite de manière à minimiser le courant d'obscurité de la photodiode. L'épaisseur de la couche **2** est ici de 0,1 $\mu$m,

mais elle pourrait être plus fine, par exemple 50 nm voire moins. De plus, la minceur de la couche de collecte **2** permet de limiter les phénomènes de génération ou de recombinaison de porteurs de charges dans la zone de déplétion de la jonction P-N et de limiter la circulation de ces porteurs par effet tunnel. De plus, en raison de cette faible épaisseur, la couche **2** interagit peu avec des rayonnements perturbateurs, comme les rayons infrarouges thermiques.

Sur la couche de collecte **2,** on dépose une couche de confinement **3** destinée à confiner les photoporteurs essentiellement dans la couche de collecte **2.** A l'instar des couches **1** et **2,** la couche de confinement **3** est réalisée en matériau semi conducteur présentant le premier type de conductivité, à savoir ici le type P, avec un gap supérieur à celui de la couche de collecte **2.** L'épaisseur de la couche de confinement **3** est de 0,2 $\mu$m à quelques $\mu$m. De préférence, le type de conductivité des couches **1, 2** et **3** est choisi P.

Par ailleurs, la photodiode comprend en outre une région **4** qui s'étend transversalement par rapport aux plans, sensiblement parallèles entre eux, que forment les couches **1, 2** et **3**. Ainsi, la région **4** traverse les couches **2** et **3,** avec lesquelles elle entre donc en contact électrique.

En pratique, pour réaliser une telle région **4,** on implante, ou, comme illustré en figure 2, on grave d'abord creux à la surface de la couche de confinement **3** et sur une profondeur quelconque et au maximum s'arrêtant dans la couche d'interaction **1**. Ensuite, de manière à former une jonction P-N avec l'empilement des couches **1, 2** et **3,** la région **4** est réalisée par conversion de type pendant la gravure ou par implantation ou diffusion après gravure. Elle présente un type de conductivité opposé au type de conductivité de ces couches **1, 2** et **3.** En l'occurrence, la région **4** est donc constituée d'un matériau semi conducteur dopé de type N, quand les couches **1, 2** et **3** sont de type P.

Les opérations de réalisation de la région **4** sont réalisées de manière conventionnelle et la forme est déterminée en fonction de la superficie de l'interface de jonction P-N nécessaire à la collecte des photoporteurs.

En outre, la région **4** ne pénètre pas nécessairement au sein de la couche **1.** Cependant, en raison des contraintes nées des techniques de réalisation, on fait pénétrer légèrement (le moins possible) la région **4** au sein de la couche **1,** afin d'être certain que ladite région **4** traverse la couche **2.**

Dans les exemples de réalisation illustrés par les figures 1 et 2, les trois couches **1, 2** et **3** sont dopées selon un premier type de conductivité, ici le type P, à un niveau d'environ $N_A$ = $1.10^{16}$ cm$^{-3}$, où $N_A$ représente la concentration des états accepteurs, tandis que la région **4,** située en fond de gravure, possède un niveau de dopage selon le type de conductivité opposé, c'est-à-dire N, d'environ $N_D$ = $5.10^{16}$ cm$^{-3}$, où $N_D$ représente la concentration des états donneurs.

Puis, on recouvre la couche de confinement **3** d'une première couche de passivation **5** qui est électriquement neutre. La région **4** est mise en contact avec un matériau électriquement conducteur destiné à former un plot **6,** par exemple de lecture, pour transmettre les signaux électriques formés par les photoporteurs collectés au niveau de la jonction P-N vers le circuit d'exploitation du détecteur (non représenté). Le matériau constitutif du plot de lecture **6** est en contact électrique avec le matériau formant la région **4,** tandis qu'il est isolé de la couche de confinement **3** par la couche de passivation **5.** Cette couche **5** peut être réalisée avant la formation de la région **4.** Dans le cas de la figure 2, le puits de gravure est comblé par le matériau conducteur.

Par ailleurs, avantageusement, la couche d'interaction **1** présente un gradient de composition propre à générer un champ électrique apte à mouvoir les photoporteurs de la couche d'interaction **1** vers la couche de collecte **2.** Ainsi, lorsque la photodiode fonctionne sous polarisation inverse, ce champ électrique moteur « pousse » les photoporteurs vers la couche de collecte **2.**

Comme le montre le diagramme à gauche de la figure 2, pour la couche d'interaction **1,** la fraction x de cadmium varie de 0,62 au niveau de la surface de détection à 0,5 au niveau de la couche de collecte **2.** Pour la couche de collecte **2,** la fraction de cadmium x contenue dans la couche de collecte 2 est de 0,3 (x < 0,5). Cette structure permet de réaliser une détection avec un facteur de bruit faible d'environ 1 (F = 1).

De même, la composition de la couche de confinement **3** peut être graduée de manière à former un champ électrique confinant davantage les photoporteurs dans la couche de collecte **2.** Un tel gradient est également visible sur les diagrammes placés à gauche des figures 2, 3, 6 et 7.

Par conséquent, lorsque la jonction P-N est soumise à une polarisation inverse déterminée, les photoporteurs libérés par les interactions entre les rayons incidents et la couche d'interaction, subissent une multiplication par effet d'avalanche, en raison de l'étroitesse de la bande interdite de la couche de collecte **2.** En effet, sous la même tension de polarisation inverse, la multiplication de photoporteurs dans les zones de déplétion des jonctions P-N situées entre la région **4** et chacune des couches **1** et **3** s'avère négligeable du fait de la largeur plus importante de la bande interdite, ou gap, de ces couches. Par conséquent, la multiplication des photoporteurs est réalisée majoritairement par la jonction P-N située entre la région **4** et la couche de collecte **2.**

Ainsi, la photodiode selon l'invention permet d'obtenir un gain élevé sous une faible tension de polarisation inverse, avec un courant d'obscurité (dû au courant de diffusion) et des courants tunnel insignifiants en raison de la minceur de la couche de collecte **2.** Le facteur de réduction de tels courants est compris entre 10 et 1 000 par rapport à un détecteur possédant une épaisseur adaptée à la détection d'un rayonnement dont l'énergie est proche du gap de la couche de collecte **2** (5 à 10 $\mu$m).

De même, les phénomènes de génération et de recombinaison des photoporteurs dans la zone de déplétion sont limités.

Par conséquent, compte tenu de ce fonctionnement à faible courant d'obscurité, il est possible d'augmenter la sensibilité du détecteur et/ou d'augmenter la température de fonctionnement au delà de ce que permettaient les photodiodes de l'art antérieur, sans pour autant dégrader le rapport signal sur bruit.

De plus, la construction de la photodiode de la présente invention est relativement simplifiée par rapport au détecteur planaire de l'art antérieur, car elle ne nécessite pas la réalisation d'un anneau de garde. En effet, les effets de la courbure de la jonction sont limités par l'emplacement dans la couche **1** de fort gap, de la courbure maximale de la jonction, quand la région **4** se termine à l'intérieur de la couche d'interaction **1.**

En outre, comme la photodiode présente de faibles dimensions, son encombrement et sa capacité électrique sont réduits, ce qui diminue le temps de réponse de la photodiode. Il est donc possible d'acquérir des images plus rapidement qu'avec les photodiodes de l'art antérieur.

Par conséquent, la photodiode des figures 1 et 2 fonctionnant par effet d'avalanche, présentent les avantages suivants :

- un gain important sous une faible tension de polarisation inverse, y compris pour détecter un rayonnement de longueur d'onde courtes ;
- un facteur de bruit faible et typiquement égal à 1 ;
- un courant d'obscurité faible et/ou une température de fonctionnement de la photodiode élevée ;
- une faible sensibilité au rayonnement thermique émis par les objets échauffés ;
- une capacité électrique faible..

La figure 3 présente une photodiode de structure analogue à celle de la photodiode illustrée par la figure 2. Elle s'en distingue néanmoins par la présence de trois couches **20, 21, 22,** se substituant à la couche **2** de la photodiode de la figure 2.

Comme le montre le diagramme présentant la variation de la composition x des matériaux semi conducteurs de la photodiode, les couches **20** et **22** qui encadrent la couche **21** présentent un gradient de composition. Cette composition graduée des couches **20** et **22** permet de ménager une transition « en douceur » pour les photoporteurs circulant de la couche **1** vers la couche **21,** qui joue le même rôle que la couche de collecte **2,** à savoir collecter les photoporteurs.

Dans le cas de la figure 3, les couches **20** à **22** sont choisies relativement minces de manière notamment à minimiser leur sensibilité à certains rayonnements comme les rayonnements infrarouge thermiques. L'adjonction des couches de « transition » **20** et **22** permet de réduire la formation de défauts au niveau des hétérojonctions que représentent les interfaces de la couche de collecte **21**. Partant, elles améliorent les performances du détecteur, car cela permet de diminuer le courant d'obscurité et d'augmenter la tenue sous polarisation inverse.

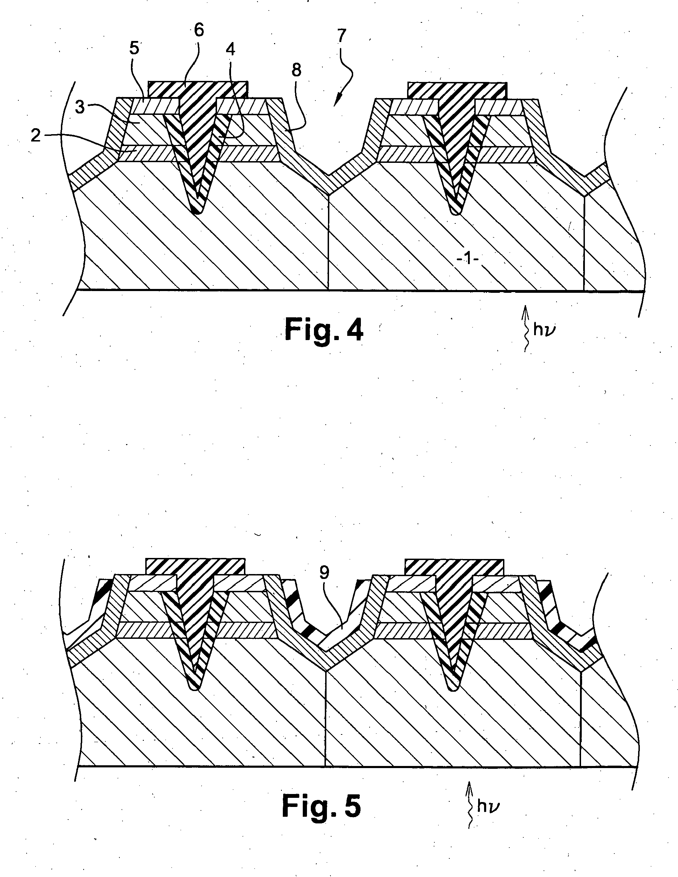

La figure 4 présente la juxtaposition de deux photodiodes selon un autre mode de réalisation de l'invention. L'empilement des couches de matériaux semi conducteurs est ici semblable à celui représenté sur la figure 2. Les couches **1, 2** et **3,** la région **4** et la couche **5** ainsi que le plot **6** remplissent les mêmes fonctions que les éléments portant ces références numériques décrits en relation avec la figure 2.

De plus, chaque photodiode est délimitée par une zone **7** exempte de matière et qui s'étend en profondeur sur toute la hauteur des couches de collecte **2** et de confinement **3** ainsi que sur une partie de la hauteur de la couche d'interaction **1.** Dans la zone **7,** l'empilement constitutif de la photodiode est recouvert par une deuxième couche de passivation **8**. La deuxième couche de passivation **8** peut être avantageusement réalisée en même temps que la deuxième couche de passivation **5**. Ces deux couches ne peuvent même constituer qu'une seule et même couche.

Par conséquent, chaque photodiode du détecteur illustré par la figure 4 présente la forme d'une « mesa » saillante au dessus de la couche d'interaction **1** commune aux photodiodes adjacentes. La couche de passivation **8** permet de protéger les flancs des tranches que forment les couches **2** et **3** et une partie de la couche **1** dans l'empilement de la photodiode. De plus, la deuxième couche de passivation **8** est apte à minimiser les recombinaisons de photoporteurs avec les défauts situés aux interfaces entre les couches semi conductrices **1, 2** et **3** et la couche de passivation **8.**

Une telle structure en « mesa » du détecteur conforme à l'invention permet de diminuer la surface de diffusion que les photoporteurs doivent traverser avant d'être collectés pas la jonction P-N par rapport aux photodiodes illustrées par les figures 1 et 2. Les photoporteurs sont ainsi « contraints » de converger vers la jonction P-N au niveau de la région **4**. Par conséquent, le temps de réponse d'un tel détecteur est notablement réduit. Bien évidemment, cette réalisation peut être adaptée à la photodiode illustré par les figures 1 et 3.

La figure 5 présente une variante du détecteur illustré par la figure 4, dans laquelle la deuxième couche de passivation **8** est revêtue d'une couche de métallisation **9**. Dans l'exemple de la figure 5, la couche de métallisation **9** recouvre les flancs et le fond des gravures définissant les « mesas ». Néanmoins, il faut simplement que la couche de métallisation **9** recouvre la couche de passivation **8** en regard des couches **2** et **3,** si bien que le fond de la zone **7** peut être exempt de dépôt métallique.

Au cours du fonctionnement, la couche de métallisation, qui est commune à l'ensemble des photodiodes composant le détecteur, est portée à un potentiel polarisateur de façon à accumuler des porteurs de charge sur les interfaces entre les couches semi conductrices **1, 2** et **3** et la deuxième couche de passivation **8**. Une telle accumulation de porteurs de charge permet de générer un champ électrique apte à accélérer les photoporteurs en direction de la jonction P-N. Par conséquent, un tel champ électrique permet de réduire le temps de réponse de chaque photodiode et, partant d'améliorer les performances du détecteur matriciel.

Les photodiodes décrites précédemment peuvent fonctionner comme capteur unique ou peuvent former un capteur élémentaire au sein d'une matrice de détection.

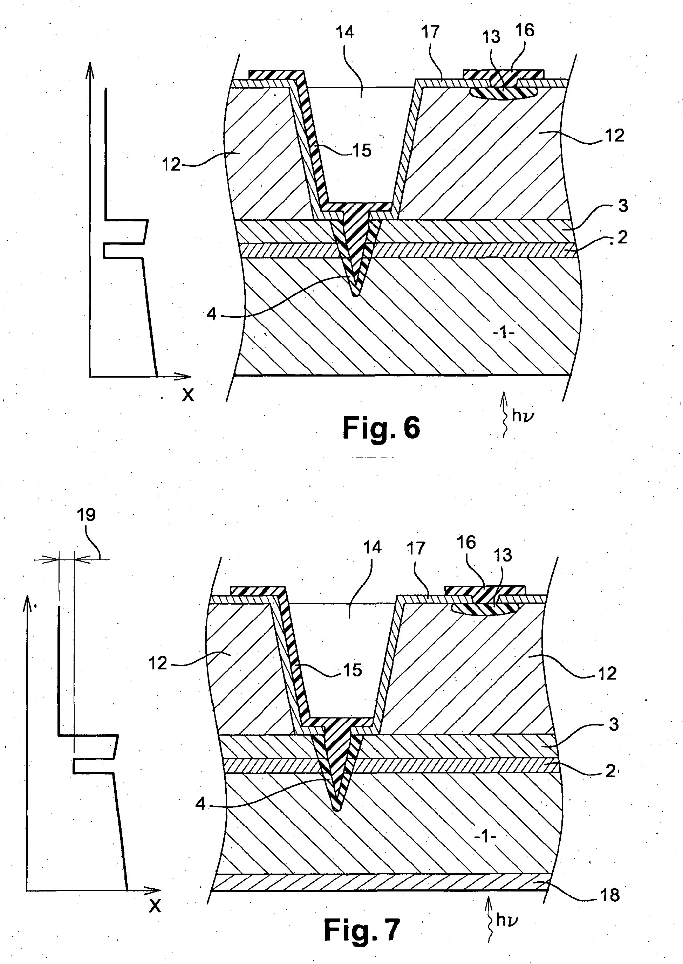

La figure 6 présente une autre forme de réalisation de l'invention, à savoir un détecteur bi spectral capable de réaliser la détection de deux rayonnements présentant deux spectres d'énergie distincts.

Plus précisément, la figure 6 présente un capteur élémentaire d'un tel détecteur comprenant une photodiode conforme à l'invention et semblable à celle illustrée par la figure 2. Cette photodiode à avalanche, composée des couches semi conductrices **1, 2** et **3** permet, à l'instar de celle de la figure 2, de détecter une bande de rayonnements infrarouges. Le fonctionnement de cette première photodiode est semblable à celui de la photodiode décrite en relation avec la figure 2, si bien qu'il n'est pas répété ici.

Une diode planaire est superposée à la photodiode à avalanche **1-4**. Les caractéristiques de cette photodiode planaire sont déterminées de manière à détecter une deuxième bande spectrale, distincte de la première, par exemple des rayons infrarouges de longueurs d'onde supérieures à celles détectées par la photodiode à avalanche.

Typiquement la photodiode à avalanche permet de réaliser un détecteur amplifié sensible aux longueurs d'ondes λ, inférieures à 3 μm et la diode planaire forme un détecteur passif sensible aux rayonnements thermiques de longueur d'onde supérieures à 3 μm Ces détecteurs amplifiés et passifs peuvent fonctionner en cohérence temporelle.

En pratique, une couche d'interaction supplémentaire **12** recouvre directement la couche de confinement **3** de la photodiode à avalanche, c'est-à-dire que celle-ci n'est pas recouverte par la première couche de passivation. La couche d'interaction supplémentaire **12** est constituée d'un matériau semi conducteur présentant le même type de conductivité que les couches **1** à **3,** en l'occurrence le type P. De plus, elle présente une bande interdite plus étroite que celle de la couche de confinement **3.** Ainsi, compte tenu de la différence entre les gaps des couches **3** et **12,** les photoporteurs libérés lors des interactions entre les rayons incidents et la couche d'interaction supplémentaire **12** ne migrent pas, à la température de fonctionnement du détecteur, à travers l'hétérojonction vers la couche **3.**

Localement, une région **13** de la couche d'interaction supplémentaire **12** est convertie, c'est-à-dire que son dopage est modifié de manière à former une jonction P-N pour collecter les photoporteurs libérés dans la couche **12.** De manière classique, la région **13** se trouve à la surface supérieure de la couche **12.** La région **13** est en contact avec un plot électriquement conducteur **16,** lequel est apte à transmettre les signaux électriques formés par les photoporteurs jusqu'à un circuit d'exploitation.

Une couche de passivation **17** recouvre la majeure partie de la couche d'interaction supplémentaire **12** de manière à protéger cette dernière des dégradations mécaniques ou chimiques.

Par ailleurs, la couche **12** comporte une zone **14** exempte de matière. La zone **14** est obtenue par une gravure réalisée jusqu'à la profondeur de la couche de confinement **3.** On peut alors déposer une couche de métallisation **15** au fond et sur au moins un flanc de la gravure **14,** de manière à conduire les signaux électriques formés par les photoporteurs dans la photodiode à avalanche jusqu'au plot électriquement conducteur **16.** La couche de métallisation **15,** électriquement conductrice, est apte à transmettre ces signaux électriques à un circuit d'exploitation.

Ainsi, la photodiode à avalanche et la diode planaire sont connectées de manière indépendante au moyen des couches de métallisation **15** et **16,** lesquelles peuvent ensuite être connectées au circuit d'exploitation par l'intermédiaire de billes d'indium (In) ou de tout autre moyen de connexion. La juxtaposition de tels capteurs élémentaires permet de créer un détecteur matriciel pour réaliser une détection bispectrale.

Comme cela a été exposé en relation avec les figures 1 à 5, la minceur de la couche de collecte **2** permet de limiter sa sensibilité aux rayonnements thermiques. Par exemple, la détection d'un faible flux laser de longueur d'onde $\lambda$, comprise entre 1 $\mu$m et 3 $\mu$m est peu influencée par des rayonnements thermiques car ces derniers sont très peu absorbés par la couche de collecte **2.** On peut ainsi réaliser une mesure de distance par réflectométrie laser en cohérence temporelle avec l'acquisition d'une image thermique par la diode planaire. Cette configuration est intéressante, car les compositions des couches **2** et **12** peuvent être choisies de façon indépendante.

La figure 7 présente une variante de la figure 6, dans laquelle on peut disposer des couches diélectriques transparentes aux rayonnements sensibles à détecter sur la face arrière **18** du détecteur de manière à former un filtre optique, afin de réduire davantage l'absorption des rayonnements thermiques. Un tel filtre présente alors les caractéristiques suivantes :

- une transmission élevée, typiquement supérieure à 90%, pour les longueurs d'onde inférieures à la longueur d'onde de coupure de la photodiode à avalanche $\lambda_{APD}$ ;
- une transmission faible, typiquement inférieure à 1%, pour une bande de longueur d'onde comprise entre la longueur d'onde de coupure de la photodiode à avalanche $\lambda_{APD}$ et la longueur d'onde de coupure $\lambda_{C2}$ de la couche de collecte **2** ;
- une transparence élevée pour des longueurs d'onde supérieures à la longueur d'onde de coupure $\lambda_{C2}$ de la couche de collecte **2.**

L'utilisation de ce filtre **18** impose, contrairement à la figure 6, un niveau inférieur du gap de la couche d'interaction **12** par rapport à celui de la couche d'interaction **2.** Ainsi, la longueur d'onde de coupure, c'est-à-dire la longueur d'onde maximale détectable de la couche d'interaction **2** est inférieure à la longueur d'onde de coupure de la couche d'interaction **12.** Ce filtre peut bien sur s'adapter à toutes les variantes des photodiodes précédemment décrites.

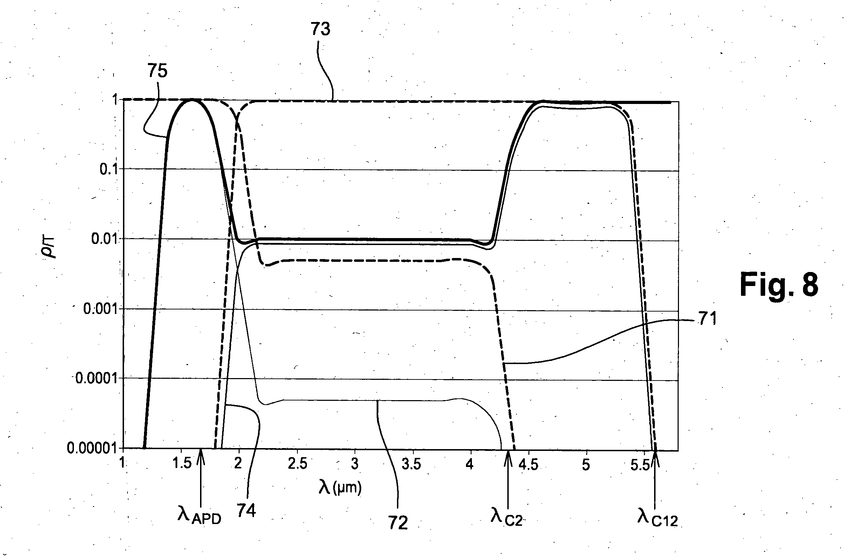

La figure 8 présente la courbe de sensibilité de la photodiode à avalanche illustrée par la figure 7 et la courbe de sensibilité de la photodiode planaire qui lui est superposée. L'axe des ordonnées représente le rendement quantique $\rho$ des diodes et la transmission **T** du filtre, tandis que l'axe des abscisses donne les longueurs d'ondes $\lambda$, concernées.

Ainsi, la photodiode à avalanche objet de l'invention, fonctionnant sans filtre (courbe **71)** ou avec filtre (courbe **72),** est apte à détecter une première bande spectrale de longueurs d'onde inférieures à $\lambda_{APD}$. L'utilisation du filtre permet de réduire le niveau de détection des longueurs d'ondes comprises entre $\lambda_{APD}$ et $\lambda_{C2}$ (le plateau de la courbe **72** est plus bas que le plateau de la courbe **71).**

La photodiode dite « thermique » planaire « prend le relais » en détectant, sans filtre (courbe **73)** une deuxième bande spectrale entre $\lambda_{APD}$ et $\lambda_{C12}$, longueur d'onde de coupure de la couche **12.**

La diode planaire avec filtre (courbe **74)** détecte les longueurs d'onde comprises entre $\lambda_{C2}$ et $\lambda_{C12}$.

La courbe **75** présente la transmission du filtre employé.

L'association de ces deux diodes permet de former un capteur élémentaire bispectral, puis un détecteur bispectral lorsque l'on juxtapose plusieurs capteurs élémentaires sous forme de matrice.

**Revendications**

1. Photodiode destinée à capter des photons incidents, comprenant un empilement d'au moins trois couches superposées réalisées en matériau semi-conducteur présentant un premier type de conductivité, ledit empilement comportant :

- une couche d'interaction (1) destinée à interagir avec les photons incidents de façon à générer des photoporteurs ;
- une couche de collecte (2) desdits photoporteurs disposée sur la couche d'interaction;
- une couche de confinement (3) destinée a confiner lesdits photoporteurs au niveau de ladite couche de collecte (2) et disposée sur la couche de collecte;

ladite couche de collecte (2) présentant une largeur de bande interdite inférieure aux largeurs de bande interdite desdites couches d'interaction (1) et de confinement (3),
ladite photodiode comprenant en outre une région (4) s'étendant transversalement par rapport aux plans desdites couches, ladite région (4) traversant la couche de collecte (2) et étant en contact avec ladite couche de collecte (2) et la couche de confinement (3), et présentant un type de conductivité opposé audit premier type de conductivité de façon à former une jonction P-N avec ledit empilement.

2.  Photodiode selon la revendication 1, *caractérisée* **en ce que** la région (4) s'étend partiellement dans la couche d'interaction (1).

3.  Photodiode selon l'une des revendications 1 et 2, *caractérisée* **en ce que** la couche de collecte (2) est plus mince que la couche d'interaction (1).

4.  Photodiode selon l'une des revendications précédentes, *caractérisée* **en ce que** la couche de collecte (2) possède une épaisseur inférieure à 0,5 $\mu$m, tandis que la couche d'interaction (1) possède une épaisseur supérieure à 1 $\mu$m.

5.  Photodiode selon l'une des revendications 1 à 4, *caractérisée* **en ce que** le matériau constituant la couche d'interaction (1) présente un gradient de composition

6.  Photodiode selon l'une des revendications 1 à 5, *caractérisée* **en ce que** la couche de confinement (3) est recouverte d'une première couche de passivation (5).

7.  Photodiode selon l'une des revendications 1 à 6, *caractérisée* **en ce qu'**elle comporte un plot de lecture (6) en contact avec ladite région (4), et apte à transmettre les signaux électriques formés par les photoporteurs à un circuit d'exploitation.

8.  Photodiode selon l'une des revendications précédentes, *caractérisée* **en ce que** la région (4) s'étend à partir d'une forme en creux.

9.  Photodiode selon l'une des revendications précédentes, *caractérisée* **en ce que** le premier type de conductivité est le type P.

10. Photodiode selon l'une des revendications précédentes, *caractérisée* **en ce que** les couches d'interaction (1) et de collecte (2) sont constituées d'un alliage de mercure, de cadmium et de tellure selon la formule $Hg_{1-x}Cd_xTe$, **en ce que** la fraction x est choisie entre 0,1 et 0,5 pour la couche de collecte (2).

11. Photodiode selon l'une des revendications précédentes, *caractérisée* **en ce que** les couches d'interaction (1) et de collecte (2) sont constituées d'un alliage de mercure, de cadmium et de tellure selon la formule $Hg_{1-x}Cd_xTe$, et **en ce que** la fraction x est choisie entre 0,1 et 1 pour la couche d'interaction (1).

12. Photodiode selon l'une des revendications précédentes, *caractérisée* **en ce que** la couche de collecte (2) comprend un empilement de couches superposées en matériaux semi-conducteurs, la couche centrale présentant une largeur de bande interdite inférieure aux largeurs de bande interdite des couches périphériques.

13. Photodiode selon l'une des revendications précédentes, *caractérisée* **en ce qu'**elle est délimitée par une zone (7) exempte de matière s'étendant en profondeur sur toute la hauteur desdites couches de collecte (2) et de confinement (3) et sur une partie de la hauteur de ladite couche d'interaction (1), la partie dudit empilement située dans ladite zone (7) étant recouverte par une deuxième couche de passivation (8).

14. Photodiode selon la revendication 13, *caractérisée* **en ce que** la deuxième couche de passivation (8) est recouverte par une couche de métallisation (9).

15. Photodiode selon l'une des revendications 6, 13 et 14, *caractérisée* **en ce que** les couches de passivation (5) et (8) sont une seule et même couche.

16. Détecteur de rayonnement électromagnétique comprenant la juxtaposition d'au moins deux diodes selon l'une des revendications 1 à 15.

17. Détecteur bispectral de rayonnement électromagnétique, *caractérisé* **en ce qu'**il comprend au moins une photodiode selon l'une des revendications 1 à 14 destinée à capter des photons d'un premier spectre d'énergie de longueurs d'onde inférieures à la longueur d'onde de coupure de la photodiode à avalanche ($\lambda < \lambda_{APD}$), sur laquelle est disposée une diode planaire comprenant une couche d'absorption (12) destinée à capter des photons d'un deuxième spectre d'énergie de longueurs d'onde comprises entre la longueur d'onde de coupure de la photodiode à avalanche et la longueur d'onde de coupure de ladite couche d'absorption (12) ($\lambda_{APD} < \lambda < \lambda_{C12}$), ainsi qu'une zone de jonction P-N (13) reliée à un plot (16) électriquement conducteur, ladite couche d'absorption (12) présentant un puits communiquant avec la région (4), une couche passivante 17) recouvrant la couche d'absorption (12) et une couche de métallisation (15) recouvrant ladite région (4) et ladite couche passivante (17) sur une partie dudit puits, le plot (16) et la couche de métallisation (15) étant aptes à conduire les signaux électriques de la photodiode vers un circuit d'exploitation.

18. Détecteur bispectral de rayonnement électromagnétique selon la revendication 17, *caractérisé* en ce *qu'*il comprend en outre une couche (18) positionnée sur la couche d'interaction (1) au niveau de sa face opposée à celle portant la couche de collecte (2), ladite couche (18) ne transmettant pas ou faiblement les photons dont la longueur d'onde λ est comprise entre la longueur d'onde de coupure de la photodiode à avalanche et la longueur d'onde de coupure de la couche de collecte (2) ($\lambda_{APD} < \lambda < \lambda_{C2}$), mais transmettant les photons dont la longueur d'onde λ est inférieure à la longueur d'onde de coupure de la photodiode à avalanche $\lambda_{APD}$, ou dont la longueur d'onde λ est supérieure à la longueur d'onde de coupure de la couche de collecte (2) $\lambda_{C2}$.


**Patentansprüche**

1. Photodiode, die dazu bestimmt ist, einfallende Photonen abzufangen, enthaltend eine Stapelung von zumindest drei übereinanderliegenden Schichten, die aus einem Halleitermaterial mit einem ersten Leitfähigkeitstyp ausgebildet sind, wobei die Stapelung aufweist:

   - eine Interaktionsschicht (1), die dazu bestimmt ist, mit den einfallenden Photonen zu interagieren, um so Ladungsträger zu erzeugen;
   - eine Sammelschicht (2) zum Sammeln der Ladungsträger, die auf der Interaktionsschicht angeordnet ist;
   - eine Einschlussschicht (3), die dazu bestimmt ist, die Ladungsträger im Bereich der Sammelschicht (2) einzuschließen und die auf der Sammelschicht angeordnet ist,

   wobei die Sammelschicht (2) eine Bandlücke aufweist, die geringer ist als die Bandlücken der Interaktionsschicht (1) und der Einschlussschicht (3), wobei die Photodiode ferner einen Bereich (4) aufweist, der sich quer zu den Ebenen der Schichten erstreckt, wobei der Bereich (4) die Sammelschicht (2) durchsetzt und mit der Sammelschicht (2) und der Einschlussschicht (3) in Kontakt steht, und einen dem ersten Leitfähigkeitstyp entgegengesetzten Leitfähigkeitstyp aufweist, so dass ein p-n-Übergang mit der Stapelung gebildet wird.

2. Photodiode nach Anspruch 1, **dadurch gekennzeichnet, dass** der Bereich (4) sich teilweise in der Interaktionsschicht (1) erstreckt.

3. Photodiode nach einem der Ansprüche 1 und 2, **dadurch gekennzeichnet, dass** die Sammelschicht (2) dünner ist als die Interaktionsschicht (1).

4. Photodiode nach einem der vorangehenden Ansprüche, **dadurch gekennzeichnet, dass** die Sammelschicht (2) eine Dicke von unter 0,5 µm besitzt, während die Interaktionsschicht (1) eine Dicke von über 1 µm besitzt.

5. Photodiode nach einem der Ansprüche 1 bis 4, **dadurch gekennzeichnet, dass** das die Interaktionsschicht (1) bildende Material einen Zusammensetzungsgradienten aufweist.

6. Photodiode nach einem der Ansprüche 1 bis 5, **dadurch gekennzeichnet, dass** die Einschlussschicht (3) mit einer ersten Passivierungsschicht (5) überzogen ist.

7. Photodiode nach einem der Ansprüche 1 bis 6, **dadurch gekennzeichnet, dass** sie ein Lesekontaktstück (6) in Kontakt mit dem Bereich (4) aufweist und in der Lage ist, elektrische Signale, die von den Ladungsträgern gebildet werden, an eine Auswerteschaltung zu übertragen.

8. Photodiode nach einem der vorangehenden Ansprüche, **dadurch gekennzeichnet, dass** der Bereich (4) sich ausgehend von einer vertieften Form erstreckt.

9. Photodiode nach einem der vorangehenden Ansprüche, **dadurch gekennzeichnet, dass** der erste Leitfähigkeitstyp vom Typ P ist.

10. Photodiode nach einem der vorangehenden Ansprüche, **dadurch gekennzeichnet, dass** die Interaktionsschicht (1) und die Sammelschicht (2) aus einer Legierung aus Quecksilber, Kadmium und Tellur nach der Formel $Hg_{1-x}Cd_xTe$ bestehen und dass der Anteil x zwischen 0,1 und 0,5 für die Sammelschicht (2) ausgewählt ist.

11. Photodiode nach einem der vorangehenden Ansprüche, **dadurch gekennzeichnet, dass** die Interaktionsschicht (1) und die Sammelschicht (2) aus einer Legierung aus Quecksilber, Kadmium und Tellur nach der Formel $Hg_{1-x}Cd_xTe$ bestehen und dass der Anteil x zwischen 0,1 und 1 für die Interaktionsschicht (1) ausgewählt ist.

12. Photodiode nach einem der vorangehenden Ansprüche, **dadurch gekennzeichnet, dass** die Sammelschicht (2) eine Stapelung von übereinanderliegenden Schichten aus Halbleitermaterialien aufweist, wobei die mittlere Schicht eine Bandlücke aufweist, die geringer als die Bandlücken der umgebenden Schichten ist.

13. Photodiode nach einem der vorangehenden Ansprüche, **dadurch gekennzeichnet, dass** sie von einem materialfreien Bereich (7) eingegrenzt wird, der sich in der Tiefe über die gesamte Höhe der Sammelschicht (2) und der Einschlussschicht (3) und über einen Teil der Höhe der Interaktionsschicht (1) erstreckt, wobei der Teil der Stapelung, der in dem Bereich (7) liegt, mit einer zweiten Passivierungsschicht (8) überzogen ist.

14. Photodiode nach Anspruch 13, **dadurch gekennzeichnet, dass** die zweite Passivierungsschicht (8) mit einer Metallisierungsschicht (9) überzogen ist.

15. Photodiode nach einem der Ansprüche 6, 13 und 14, **dadurch gekennzeichnet, dass** die Passivierungsschichten (5) und (8) ein und dieselbe Schicht sind.

16. Elektromagnetischer Strahlungsdetektor mit der Aneinanderreihung von zumindest zwei Dioden nach einem der Ansprüche 1 bis 15.

17. Bispektraler, elektromagnetischer Strahlungsdetektor, **dadurch gekennzeichnet, dass** er zumindest eine Photodiode nach einem der Ansprüche 1 bis 14 aufweist, die dazu bestimmt ist, Photonen eines ersten Energiespektrums mit Wellenlängen abzufangen, die geringer als die Cut-Off-Wellenlänge der Lawinen-Photodiode ($\lambda < \lambda_{APD}$) sind, auf welcher eine Planardiode mit einer Absorptionsschicht (12) angerordnet ist, die dazu bestimmt ist, Photonen eines zweiten Energiespektrums mit Wellenlängen zwischen der Cut-Off-Wellenlänge der Lawinenphotodiode und der Cut-Off-Wellenlänge der Absorptionsschicht (12) ($\lambda_{APD} < \lambda < \lambda_{C12}$) abzufangen, sowie mit einem p-n-Übergangsbereich (13), der mit einem elektrisch leitenden Kontaktstück (16) verbunden ist, wobei die Absorptionsschicht (12) einen mit dem Bereich (4) kommunizierenden Topf, eine Passivierungsschicht (17), mit welcher die Absorptionsschicht (12) überzogen ist, und eine Metallisierungsschicht (15) aufweist, mit welcher der Bereich (4) und die Passivierungsschicht (17) über einen Teil des Topfs überzogen sind, wobei das Kontaktstück (16) und die Metallisierungsschicht (15) dazu geeignet sind, die elektrischen Signale der Photodiode zu einer Auswerteschaltung zu leiten.

18. Bispektraler, elektromagnetischer Strahlungsdetektor nach Anspruch 17, **dadurch gekennzeichnet, dass** er ferner eine Schicht (18) aufweist, die auf der Interaktionsschicht (1) im Bereich ihrer Seite positioniert ist, die der Seite entgegengesetzt ist, welche die Sammelschicht (2) trägt, wobei die Schicht (18) nicht oder nur geringfügig die Photonen überträgt, deren Wellenlänge $\lambda$ zwischen der Cut-Off-Wellenlänge der Lawinenphotodiode und der Cut-Off-Wellenlänge der Sammelschicht (2) liegt ($\lambda_{APD} < \lambda < \lambda_{C2}$), jedoch Photonen überträgt, deren Wellenlänge $\lambda$ geringer als die Cut-Off-Wellenlänge der Lawinenphotodiode $\lambda_{APD}$ ist und deren Wellenlänge $\lambda$ größer als die Cut-Off-Wellenlänge der Sammelschicht (2) $\lambda_{C2}$ ist.

**Claims**

1. A photodiode designed to capture incident photons comprising a stack of at least three superposed layers of semiconductor materials having a first conductivity type, said stack comprising:

   - an interaction layer (1) designed to interact with incident photons so as to generate photocarriers;
   - a collection layer (2) to collect said photocarriers; positioned on the interaction layer ;
   - a confinement layer (3) designed to confine said photocarriers in said collection layer (2); and positioned on the collection layer ,

   said collection layer (2) having a band gap less than the band gaps of said interaction layer (1) and confinement layer (3),
   said photodiode also comprising a region (4) which extends transversely relative to the planes of said layers, said region (4) crossing the collection layer (2) and being in contact with collection layer (2) and confinement layer (3) and having a conductivity type opposite to said first conductivity type so as to form a p-n junction with said stack.

2. A photodiode as claimed in claim 1, **characterised in that** region (4) extends partially into interaction layer (1).

3. A photodiode as claimed in any of claims 1 and 2, **characterised in that** collection layer (2) is thinner than interaction layer (1).

4. A photodiode as claimed in any of the above claims, **characterised in that** collection layer (2) has a thickness less than 0.5 $\mu$m whereas interaction layer (1) has a thickness greater than 1 $\mu$m.

5. A photodiode as claimed in any of claims 1 to 4, **characterised in that** the material which constitutes interaction layer (1) has a composition gradient.

6. A photodiode as claimed in any of claims 1 to 5, **characterised in that** confinement layer (3) is covered in a first passivation layer (5).

**7.** A photodiode as claimed in any of claims 1 to 6, *characterised* **in that** it comprises read contact (6) which is in contact with region (4) and is capable of transferring the electrical signals produced by photocarriers to an analysis circuit.

**8.** A photodiode as claimed in any of the above claims, *characterised* **in that** region (4) extends starting from a hollow shape.

**9.** A photodiode as claimed in any of the above claims, *characterised* **in that** the first conductivity type is p-type.

**10.** A photodiode as claimed in any of the above claims, *characterised* **in that** interaction layer (1) and collection layer (2) consist of an alloy of mercury, cadmium and tellurium having the formula $Hg_{1-x}Cd_xTe$ and **in that** fraction x is selected as 0.1 to 0.5 for collection layer (2).

**11.** A photodiode as claimed in any of the above claims, *characterised* **in that** interaction layer (1) and collection layer (2) consist of an alloy of mercury, cadmium and tellurium having the formula $Hg_{1-x}Cd_xTe$ and **in that** fraction x is selected as 0.1 to 1 for interaction layer (1).

**12.** A photodiode as claimed in any of the above claims, *characterised* **in that** collection layer (2) comprises a stack of superposed layers made of semiconductor materials with the central layer having a band gap which is less than the band gaps of the peripheral layers.

**13.** A photodiode as claimed in any of the above claims, *characterised* **in that** it is delineated by an area (7) which is free of material and extends depth wise over the entire height of the collection layer (2) and confinement layer (3) and over part of the height of said interaction layer (1), that part of said stack located in said area (7) being covered in a second passivation layer (8).

**14.** A photodiode as claimed in claim 13, *characterised* **in that** second passivation layer (8) is covered by metallisation layer (9).

**15.** A photodiode as claimed in any of claims 6, 13 and 14, *characterised* **in that** passivation layers (5) and (8) are a single identical layer.

**16.** An electromagnetic radiation detector comprising at least two juxtaposed diodes as claimed in any of claims 1 to 15.

**17.** A dual spectrum electromagnetic radiation detector, *characterised* **in that** it comprises at least one photodiode as claimed in any of claims 1 to 14 designed to capture photons in a first energy spectrum having wavelengths less than the cut-off wavelength of the avalanche diode ($\lambda < \lambda_{APD}$) on which there is a planar diode comprising an absorption layer (12) designed to capture photons in a second energy spectrum having wavelengths between the cut-off wavelength of the avalanche diode and the cut-off wavelength of said absorption layer (12) ($\lambda_{APD} < \lambda < \lambda_{C12}$) as well as a p-n junction region (13) which is connected to an electrically conducting contact (16), said absorption layer (12) having a well which communicates with region (4), a passivation layer (17) covering absorption layer (12) and a metallisation layer (15) covering said region (4) and said passivation layer (17) over part of said well, contact (16) and metallisation layer (15) being capable of conducting electrical signals from the photodiode to an analysis circuit.

**18.** A dual spectrum electromagnetic radiation detector as claimed in claim 17, *characterised* **in that** it also comprises a layer (18) located on interaction layer (1) on its face opposite to that which receives collection layer (2), said layer (18) not transmitting or only slightly transmitting photons having a wavelength $\lambda$ between the cut-off wavelength of the avalanche photodiode and the cut-off wavelength of collection layer (2) ($\lambda_{APD} < \lambda < \lambda_{C2}$) but transmitting photons having a wavelength $\lambda$ which is less than the cut-off wavelength of the avalanche photodiode $\lambda_{APD}$ or having a wavelength $\lambda$ which is greater than the cut-off wavelength of collection layer (2) $\lambda_{C2}$.

Fig. 1

Fig. 2

Fig. 3

**Fig. 4**

hν

**Fig. 5**

hν

14  17  13  16

12

15

12

3

2

4

-1-

hν

X

**Fig. 6**

19

16  13

14  17

12

15

12

3

2

4

-1-

18

hν

X

**Fig. 7**

15

Fig. 8

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- The HgCdTe Electron Avalanche Photodiode. *Proc. SPIE,* vol. 5564, 44-53